Europäisches Patentamt

European Patent Office

Office européen des brevets

(19)

(11) Publication number: 0 409 347 A1

# EUROPEAN PATENT APPLICATION

(21) Application number: 90201941.3

(22) Date of filing: 16.07.90

(51) Int. Cl.5: **H02G 3/14**, H05K 5/00,
F16B 21/06

(30) Priority: 21.07.89 NL 8901897

(43) Date of publication of application:
23.01.91 Bulletin 91/04

(84) Designated Contracting States:
AT BE CH DE DK ES FR GB GR IT LI LU NL SE

(71) Applicant: ERICSSON TELECOMMUNICATIE
B.V.
1, Haansbergseweg
NL-5121 LG Rijen(NL)

(72) Inventor: van den Elshout, Adrianus Petrus
Aloysius
12, Echbronk
NL-4847 AN Teteringen(NL)

(74) Representative: van der Arend, Adrianus G.A.,
Ir. et al
EXTERPATENT B.V. P.O. Box 90649
NL-2509 LP The Hague(NL)

(54) Coupling system for coupling two parts of a housing.

(57) Coupling system (8) for coupling two parts (1,2) of a housing, comprising a lug (13) fitted on an inside wall (9) of one of the parts (1) and a stop (6) which is fitted on the other part (2) and over which the lug (13) engages when the parts (1,2) are coupled in order to keep the parts (1,2) coupled to each other, a recess (16) being formed in a wall (9) of one part (1) in the vicinity of the lug (13) in order to allow through an elongated end (15) of a tool by means of which the lug (13) can be pressed off the stop (6) in order to disconnect the parts (1,2). When the parts (1,2) are coupled the faces of the lug (13) and the stop (6) in contact with each other run essentially parallel to the wall (9) with the recess (16). The lug (13) is fixed to a flange (12) running essentially at right angles to the wall (9) with the recess (16) and having a free end (18) at the side of said wall (9) and an end (11) lying opposite and fixed to the wall (9) at a distance from it. The recess (16) is suitable for allowing through the end (15) of the tool in such a way that the flange (12) can be turned with it about the top end (11) thereof in order to release the lug (13) and the stop (6) from each other.

Fig. 4

## COUPLING SYSTEM FOR COUPLING TWO PARTS OF A HOUSING.

The invention relates to a coupling system for coupling two parts of a housing, comprising a lug fitted on an inside wall of one of the parts and a stop which is fitted on the other part and over which the lug engages when the parts are coupled in order to keep the parts coupled to each other, a recess being formed in a wall of one part in the vicinity of the lug in order to allow through an elongated end of a tool by means of which the lug can be pressed off the stop in order to disconnect the parts.

A coupling system of this kind is known in practice. In the case of the known coupling system the contact faces of the lug and of the stop run essentially at right angles to the inside wall to which the lug is fixed, and the end of the tool can be moved parallel to said contact faces through a recess in another wall running at right angles to the above-mentioned inside wall in order to press the lug away from the stop.

The known coupling system has the disadvantage that the lug can be moved only in the direction running parallel to the contact faces of the lug and the stop, which means that such a coupling system can be used only close to a side edge of the housing. Besides, the lug swings away from the stop in such a direction while it is being pressed away that, in order to prevent play, the contact faces have to run at a slight angle, e.g. 1.5°, in such a way that the contact face of the lug forms an obtuse angle with a radius running from an axis of rotation of the lug. This means that the coupling between the parts can become detached accidentally through vibration or shaking.

The object of the invention is to eliminate the disadvantages of the known coupling system.

This object is achieved according to the invention for the coupling system of the type mentioned in the preamble in that the lug and the recess are fitted in such a way on or in the same wall that when the parts are coupled the faces of the lug and the stop in contact with each other run essentially parallel to the wall with the recess, in that the lug is fixed to a flange running essentially at right angles to the wall with the recess and having a free end at the side of said wall and an end lying opposite and fixed to the wall at a distance from it, and in that the recess is suitable for allowing through the end of the tool in such a way that the flange can be turned with it about the top end thereof in order to release the lug and the stop from each other. As a result, the coupling system can be fitted at any place inside the housing, while the recess for allowing through the end of the tool for releasing the coupling is always situated close to the coupling system. Since the flange to which the lug is fixed turns about an axis which is not situated at the side of the contact face of the lug, the contact faces of the lug and of the stop can run fully parallel to the wall with the recess, which means that accidental detachment of the coupling between the parts through shaking or vibration is prevented. The inclination of the contact faces relative to the wall with the recess can also be so negative that the angle between the contact face of the lug and the flange is smaller than 90°. This further counteracts the detachment of the coupling. Since the lug is fixed to a flange which is rotatable about an axis which relative to the recess lies past the lug, the lug and the stop can be fitted close to the wall with the recess, so that accidental detachment of the coupling through shaking or vibration is also prevented.

The fixed end of the flange is preferably fixed to the inside wall by means of a torsion bar running at a distance from and parallel to the wall with the recess and by supports fixed to the torsion bar. This produces a relatively flexible connection between the flange and the supports, so that little force is needed to press the lug away from the stop by means of the end of the tool, while the advantage of the accidental detachment of the coupling through shaking or vibration is retained.

The lug is preferably divided by a recess between the lug parts in order to allow through the end of the tool. Such a symmetrical design means that the force exerted by the end of the tool is distributed symmetrically over the coupling system, so that as a whole it need have relatively little strength.

The flange preferably runs past the lug, relative to the fixed end thereof, to the recess. This produces a greater contact face for the end of the tool.

The invention is explained with reference to the drawings. In the drawings:

Fig. 1 shows in perspective, and taken apart, a housing in which the coupling system according to the invention is used;

Fig. 2 shows on a larger scale and in perspective the part of the coupling system of Fig. 1;

Fig. 3 shows a cross-section of the coupling system with coupled parts of the housing; and

Fig. 4 shows a cross-section of the coupling system in which the coupling is released.

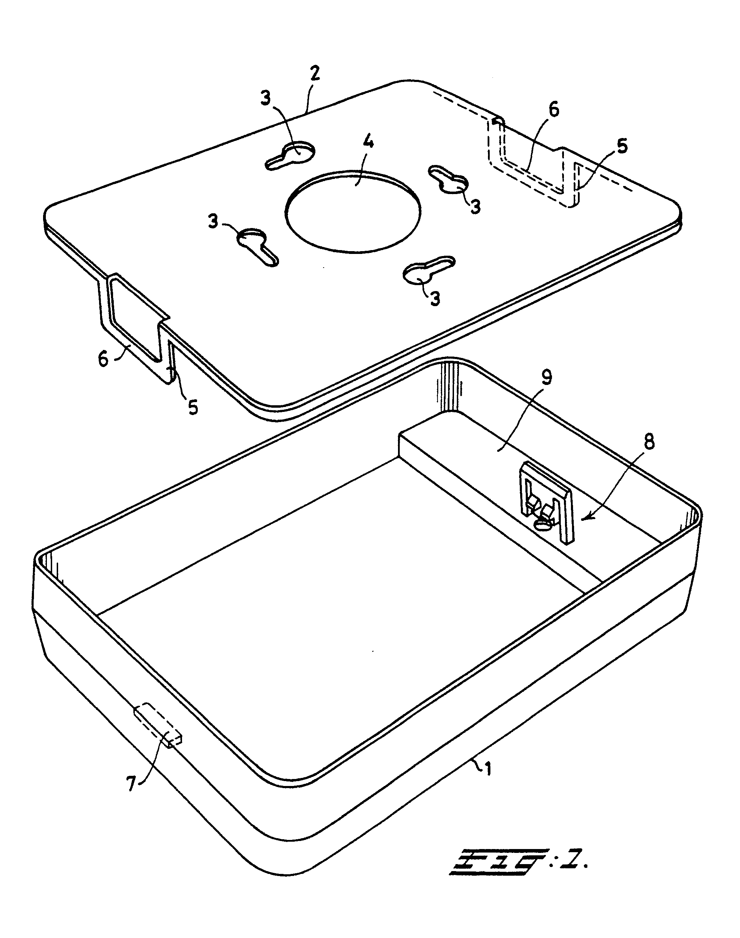

Fig. 1 shows a housing which comprises a holder 1 and a wall fixing plate 2. The plate 2 has passages 3 to allow through screws (not shown) and an aperture 4 for the passage of, for example, an electric cable (not shown). The plate 2 can be fixed to a wall by means of screws (not shown), following which the holder 1 is fixed to the plate 2. The invention is not, however, restricted to such a housing and can relate to any type of housing, for example a housing comprising two shells the edges of which are in contact with each other after the coupling is made, in order to achieve an essentially tight housing.

The plate 2 has two flanged edge parts 5, each forming a stop or bearing part 6.

The holder 1 has on an inside wall a projection 7 which corresponds to one of the stops 6, and which projects into the aperture formed by the edge part 5 and rests on the stop 6 when the holder 1 is coupled to the plate 2. The other stop 6 is for mating with a coupling system according to the invention which in its entirety is indicated by the reference number 8 and is fitted on an inside wall 9 of the housing. The coupling system 8 can be fitted at any position inside the holder 1 on the wall 9, provided that the plate 2 has a corresponding stop. Such a coupling system 8 can also be used instead of the projection 7.

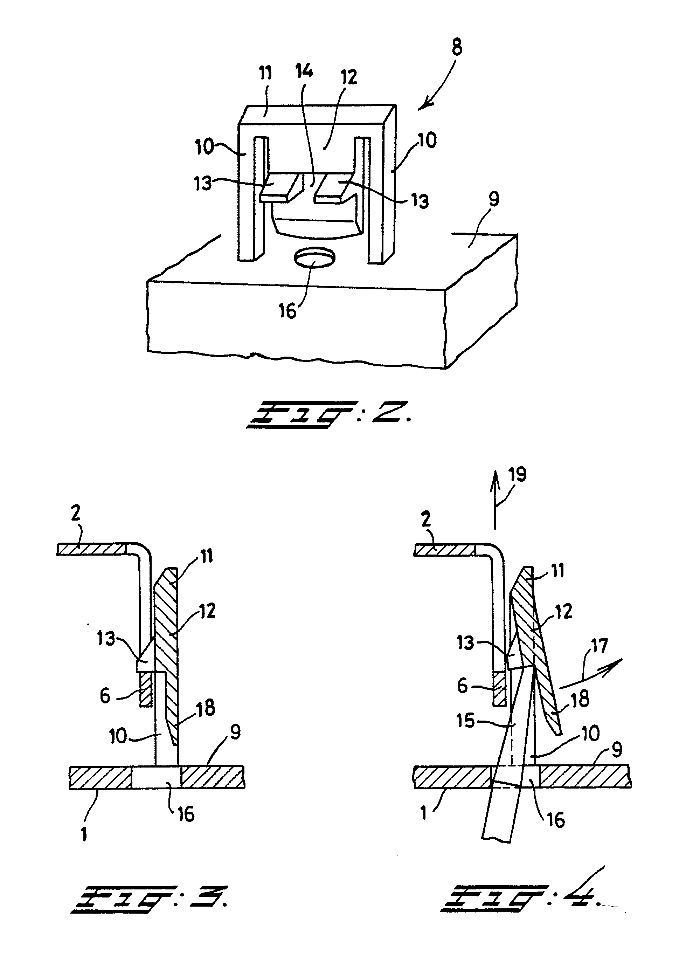

As can be seen in Fig. 2, the coupling system 8 has two supports 10 going out from the wall 9, a connecting part 11 formed between the supports at a distance from the wall 9, a flange 12 going out to the wall 9, with two lugs 13 having between them a recess 14 which is suitable for allowing through an elongated end 15 of a tool which can be inserted through an aperture 16 formed in the wall 9.

When the parts are coupled the situation shown in Fig. 3 is obtained. The contact faces of the lug 13 and of the stop 6 run parallel to the wall 9.

When, as shown in Fig. 4, the elongated end 15 of a tool, for example a screwdriver, is inserted through the aperture 16, the flange 12 can be turned away with it in the direction of the arrow 17, and the holder 1 can then be removed from the plate 2. Although in the situation shown in Fig.4 the end 15 projects into the recess 14 between the lugs 13, this is not necessary, but the end 15 can also be pressed against the bottom part 18 of the flange 12. The bottom part 18 of the flange 12 also ensures that the end 15 of the tool cannot be inserted into the housing at the wrong side of the flange 12.

The connecting part 11 acts as a torsion bar during the turning of the flange 12, in which case a relatively small force needs to be exerted on the flange 12 to press the flange 12 aside. Since, however, on the occurrence of vibrations the flange 12 vibrates very little relative to the wall 9 and the part 2 and the contact faces of the stop 6 and of the lug 13 run at right angles relative to a detachment direction indicated by the arrow 19 in order to release the parts from each other, the coupling will not become detached accidentally in the process.

## Claims

1. Coupling system for coupling two parts of a housing, comprising a lug fitted on an inside wall of one of the parts and a stop which is fitted on the other part and over which the lug engages when the parts are coupled in order to keep the parts coupled to each other, a recess being formed in a wall of one part in the vicinity of the lug in order to allow through an elongated end of a tool by means of which the lug can be pressed off the stop in order to disconnect the parts, **characterized in that** the lug and the recess are fitted in such a way on or in the same wall that when the parts are coupled the faces of the lug and the stop in contact with each other run essentailly parallel to the wall with the recess, in that the lug is fixed to a flange running essentially at right angles to the wall with the recess and having a free end at the side of said wall and an end lying opposite and fixed to the wall at a distance from it, and in that the recess is suitable for allowing through the end of the tool in such a way that the flange can be turned with it about the top end thereof in order to release the lug and the stop from each other.

2. Coupling system according to Claim 1, **characterized in that** the fixed end of the flange is fixed to the inside wall by means of a torsion bar running at a distance from and parallel to the wall with the recess and by supports fixed to the ends of the torsion bar.

3. Coupling system according to Claim 1 or 2, **characterized in that** the lug is divided by a recess between the lug parts in order to allow through the end of the tool.

4. Coupling system according to one of the preceding claims, **characterized in that** the flange, relative to the fixed end thereof, runs past the lug to the recess.

FIG:1.

FIG. 2.

FIG. 3.

FIG. 4.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | FR-A-2614169 (MANG)<br>* page 3, line 25 - page 6, line 7; figures 1-5 * | 1, 2 | H02G3/14<br>H05K5/00<br>F16B21/06 |
| Y | GB-A-2197383 (PLESSEY)<br>* page 1, lines 102 - 122; figures 2-4 * | 1, 2 | |
| A | DE-U-8020040 (SIEMENS)<br>* the whole document * | | |

TECHNICAL FIELDS
SEARCHED (Int. Cl.5 )

H02G
H05K

The present search report has been drawn up for all claims

| Place of search | Date of completion of the search | Examiner |
|---|---|---|
| THE HAGUE | 24 OCTOBER 1990 | VAN DER WAL W. |